# EUROPEAN PATENT APPLICATION

(11) **EP 3 434 890 A1**
(43) Date of publication of application: **30.01.2019**
(21) Application number: 18183036.5
(22) Date of filing: 12.07.2018
(51) Int. Cl.: F02M 61/18, F02M 61/16

(54) **COATING MATERIAL**

(30) Priority: 28.07.2017 GB 201712160
(71) Applicant: Delphi Technologies IP Limited, Saint Michael (BB)
(72) Inventor: VIT, Romain, 41120 Chailles (FR); TAPIN, Christophe, 41000 Saint Sulpice de Pommeray (FR); VILLAIN, Géraldine, 37400 Amboise (FR); CORMIER, Brice, 45000 Orléans (FR)
(74) Representative: Delphi France SAS

(57) **Abstract**

A coating material wear resistant for the life time of a valve and electrically conductive, said material being of the family of the Tetrahedral Amorphous Carbon (ta-C) hydrogen free, said material having a Vickers hardness inferior to 4000 HV.

## Description

### TECHNICAL FIELD

The present invention relates to a coating material adapted to coat a seating face of a valve member and, more particularly, the seating face of a needle of a fuel injector controlled with a close loop strategy.

### BACKGROUND OF THE INVENTION

To improve diesel fuel injection in the cylinders of an internal combustion engine, a close loop strategy is implemented wherein a command unit receives signal relevant of the position of the needle valve member of the fuel injectors. Several design of electric switch have been designed, a most efficient utilising the tip end of the needle and the complementary seating face to establish an electrical contact. Unfortunately, said faces wear under pressure and a protective coating having mechanical durability and low stable electrical conductivity is required.

### SUMMARY OF THE INVENTION

Accordingly, it is an object of the present invention to resolve the above mentioned problems in providing a coating material adapted for coating the sealing face of a valve assembly, said material being wear resistant for the life time of the valve and being electrically conductive so that said valve assembly can be controlled with a close loop strategy, said material being of the family of the Tetrahedral Amorphous Carbon (carbon) ta-C alloys hydrogen free wherein said material has a Vickers hardness inferior to 4000 HV.

Preferably, said material has a Vickers hardness of about 3000 HV.

Also, said coating material contains a fraction of sp3 between 40% and 45% and, a complementary fraction of sp2 ranging between 60% and 55%.

Preferably, the fraction of sp3 is preferably closer to 40%.

Also, said coating material is adapted to coat a face of a member of a valve assembly with a coating layer having a thickness comprised between 0.7 µm and 1.2 µm and, preferably 1.0 µm.

The invention extends to a valve member of a valve assembly adapted to be guided in a housing defined in the body of said valve assembly, said valve member defining a sealing face adapted to be urged against a complementary seating face of the body, the sealing face of the valve member being coated with a material as previously described.

The invention extends to a valve assembly comprising such a valve member.

More particularly, the valve member is a needle valve member of a fuel injector, said needle valve member having an elongated core and a tip end defining a sloped sealing face adapted to be urged against a fixed seat face defined on a body of the injector in order to close a fuel passage toward fuel spray holes, the sloped face of said valve member being coated with a coating material as previously described.

The invention extends to a fuel injector having a body wherein is guided such a needle valve member.

### BRIEF DESCRIPTION OF THE DRAWINGS

The present invention is now described by way of example with reference to the accompanying drawings in which:
Figure 1 is an axial section a diesel fuel injector controlled with a close loop strategy.
Figure 2 is a view magnifying an extremity of the injector of figure 1.
Figure 3 is a ternary phase diagram of bonding in amorphous carbon-hydrogen alloys.

### DESCRIPTION OF THE PREFERRED EMBODIMENTS

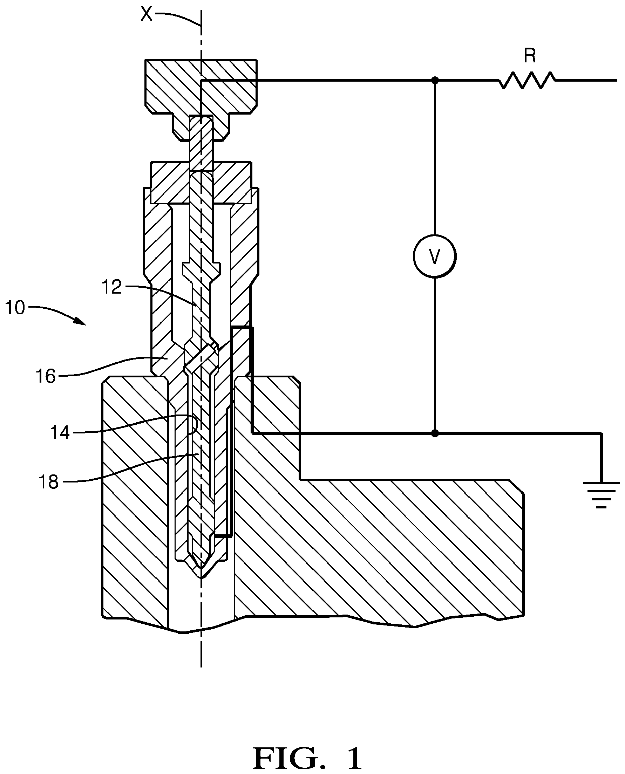

In a diesel fuel injector 10, a needle valve member 12 guided in a bore 14 of a nozzle body 16 between a closed position CP and an open position OP is indirectly controlled by a small electrovalve commanding a strong hydraulic drive. To make this indirect control more accurate, a close loop strategy is implemented wherein an ECU computes a command signal sent to said electrovalve as a function of an input signal S representative of the position of the needle 12, said input signal S varying when opening or closing an electrical circuit sketched on figure 1 and comprising said needle valve member 12 and said nozzle body 16.

More precisely, the needle valve member 12 has an elongated core 18 extending along a longitudinal axis X and provided with a tip end defining a sloped sealing face 20. In closed position CP said sealing face 20 of the needle 12 comes in contact against a complementary seat face 22 defined in the nozzle body 16 and closes a fluid communication toward spray holes 24 arranged through the nozzle body, thus preventing fuel injection. The two faces 20, 22 are electrically conductive and the contact between said two faces 20, 22 closes said electrical circuit and switches ON said input signal S. On the opposite, when moving toward the open position OP, the needle sealing face 20 lifts off the body seating face 22, opening said fluid communication and enabling fuel spray. The split away of the two faces 20, 22 opens the electrical circuit and switches OFF the input signal S.

The injector 10 is adapted to last for the life time of the engine the injector equips that, for a vehicle means several hundreds of thousands of kilometers representing for the injector 10 more than 500 million fuel injections or switch between the open position OP and the closed position CP.

To prevent wear and enable electrical switch the sealing face 20 is coated with a layer 26 of a coating material M that combines the necessary mechanical wear resistant and electrical conductive properties.

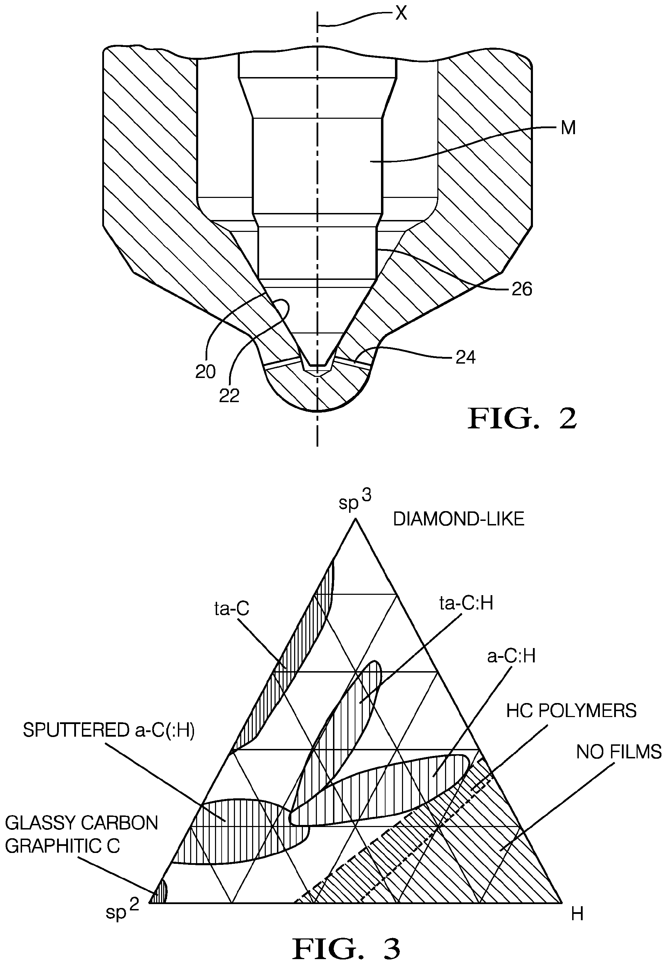

Figure 3 is the ternary phase diagram of bonding in amorphous carbon-hydrogen alloys where, in a triangle are indicated C-H alloys varying by the proportion of hydrogen and by the carbon atomic structures, sp2 and sp3, where, sp2 and sp3 are distinct hybridisation of a C-H molecule, sp2 being graphite that is electrically conductive and not wear resistant and, sp3 being diamond-like that is electrically isolating and wear resistant.

The coating material M is selected within the ta-C family that, on the diagram, is on the sp2-sp3 border representing hydrogen free alloys only containing complementary fractions of sp2 and sp3. Moreover, although the ta-C area ranges from (60% sp2 ; 40% sp3) to (10% sp2 ; 90% sp3) the complete area is not convenient for an application on a valve application.

Most of said ta-C area is too hard and not sufficiently electrically conductive (too much sp3), thus does not have the appropriate characteristics.

Numerous tests and analysis have enabled to identify a preferred coating material M that is the lowest extremity of said ta-C area, closest to the sp2 point, containing 40% sp3 and 60% of sp2 in a coating layer of 1µm thickness. The tests have enabled to slightly enlarge the possible selection to an acceptable area ranging from 40% to 45% of sp3 and a complementary fraction between 60% and 55% of sp2 and also to a coating layer thickness ranging between 0.7 µm and 1.2 µm.

Said coating layer 26 of coating material M has been primary developed in the context of a diesel fuel injector 10, for coating the needle sloped seating face 20. Coating the body seating face 22 is a symmetrical solution providing similar acceptable results. It is also possible to coat both faces 20, 22.

The domain has also been enlarged with success to other parts having faces requiring wear protection and electrical conductivity for an equivalent life time as indicated above. Such parts are, for instance, powertrain components, fuel pumps, gasoline injector, hydraulic valve or digital metering valve arranged on the inlet of a HP pump of a diesel injection equipment.

### LIST OF REFERENCES

- X: longitudinal axis
- OP: open position
- CP: closed position
- M: coating material

- 10: injector
- 12: needle valve member
- 14: bore
- 16: nozzle body
- 18: needle core
- 20: sloped sealing face of the needle
- 22: seating face
- 24: spray holes
- 26: coating layer

## Claims

1. Coating material (M) adapted for coating the sealing face (20) of a valve assembly, said material (M) being wear resistant for the life time of the valve and being electrically conductive so that said valve assembly can be controlled with a close loop strategy, said material (M) being of the family of the Tetrahedral Amorphous Carbon (ta-C) hydrogen free wherein said material (M) has a Vickers hardness inferior to 4000 HV.

2. Coating material (M) as claimed in the preceding claim wherein said material has a Vickers hardness of about 3000 HV.

3. Coating material (M) as claimed in any one of the preceding claims wherein said material contains a fraction of sp³ between 40% and 45% and, a complementary fraction of sp² ranging between 60% and 55%.

4. Coating material (M) as claimed in claim 3 wherein the fraction of sp³ is preferably closer to 40%.

5. Coating material (M) as claimed in any of the preceding claims adapted to coat a face (20) of a member of a valve assembly with a coating layer (26) having a thickness comprised between 0.7 µm and 1.2 µm.

6. Coating material (M) as claimed in claim 5 wherein the thickness of the coating layer is preferably about 1.0 µm.

7. Valve member (12) of a valve assembly adapted to be guided in a housing defined in the body (16) of said valve assembly, said valve member defining a sealing face (20) adapted to be urged against a complementary seating face (22) of the body, the sealing face of the valve member being coated with a material (M) as claimed in any of the preceding claims.

8. Valve assembly comprising a valve member as claimed in claim 7.

9. Needle valve member (12) of a fuel injector (10), said needle valve member having an elongated core (18) and a tip end defining a sloped sealing face (20) adapted to be urged against a fixed seat face (22) defined on a body (16) of the injector in order to close a fuel passage toward fuel spray holes (24), the sloped face (20) of said valve member being coated with a coating material (M) as claimed in any one of the preceding claims.

10. Fuel injector (10) having a body wherein is guided a needle valve member (12) as claimed in claim 9.
